# DEMANDE DE BREVET EUROPEEN

(11) **EP 1 146 554 A1**
(43) Date de publication de la demande: **17.10.2001**
(21) Numéro de dépôt: 01410041.6
(22) Date de dépôt: 09.04.2001
(51) Int. Cl.: H01L 21/761, H01L 21/762, H01L 21/225

(54) **Procédé de formation de couches enterrées**

(30) Priorité: 10.04.2000 FR 0004587
(71) Demandeur: STMicroelectronics S.A., 92120 Montrouge (FR)
(72) Inventeur: Gris, Yvon, 38210 Tullins (FR); Schwartzmann, Thierry, 38480 Le Versoud (FR)
(74) Mandataire: de Beaumont, Michel

(57) **Abrégé**

L'invention concerne un procédé de formation de couches enterrées disjointes et proches les unes des autres dans un composant semiconducteur. Ce procédé comprend les étapes consistant à former par implantation des zones dopées (21, 22, 23) dans un substrat semiconducteur (1) ; procéder à un recuit juste suffisant pour supprimer les défauts cristallins résultant de l'implantation ; déposer une couche épitaxiale (2) ; creuser des tranchées (25) délimitant chaque région implantée ; procéder à un recuit des couches enterrées dont la diffusion latérale est bloquée par lesdites tranchées, lesdites tranchées étant plus profondes que l'extension vers le bas des diffusions résultant desdites implantations.

## Description

La présente invention concerne le domaine de la fabrication des circuits semiconducteurs, et plus particulièrement la réalisation de couches enterrées entre un substrat et une couche épitaxiale.

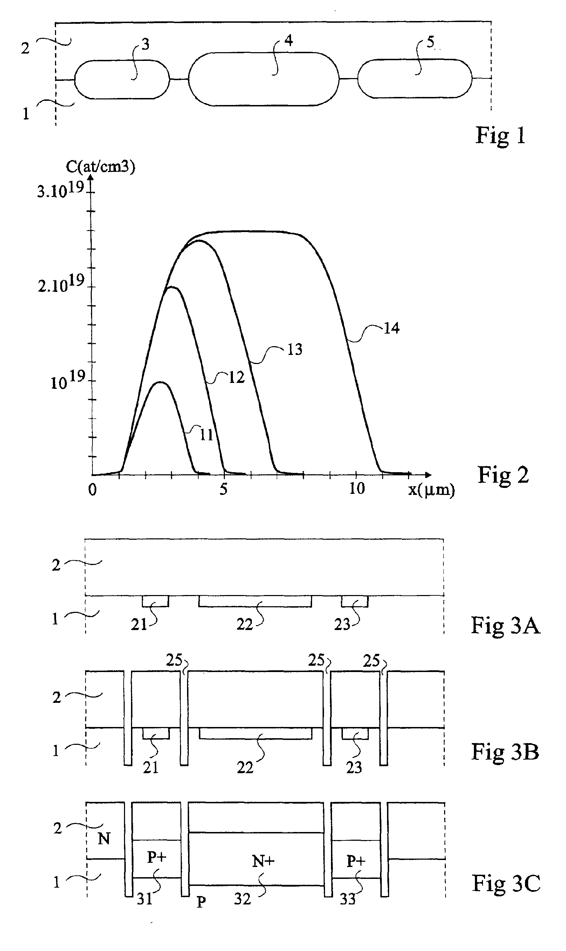

Une telle structure est représentée à titre d'exemple en figure 1. Le substrat est désigné par la référence 1, la couche épitaxiale par la référence 2 et des couches enterrées sont désignées par les références 3, 4 et 5. Si les couches 3 et 5 sont du même type, elles auront en fin de processus la même extension en hauteur. Si la couche 4 est d'un type différent, elle peut présenter une extension en hauteur distincte de celle des couches 3 et 5.

De façon classique, ces couches enterrées sont formées par implantation de dopants choisis dans le substrat avant formation de la couche épitaxiale. L'étape d'implantation est nécessairement suivie d'un bref recuit de restructuration pour éliminer les défauts structurels induits dans le substrat par l'implantation. En effet, si on laissait subsister de tels défauts structurels, la couche épitaxiale pourrait présenter des défauts. Toutefois, habituellement, on procède à un recuit plus important que le recuit nécessaire à la seule restructuration du substrat. Après l'étape d'épitaxie, par suite de diverses étapes de recuit nécessaires à une activation satisfaisante des zones enterrées et résultant inévitablement de la fabrication du circuit intégré, les couches enterrées ont diffusé verticalement et latéralement par rapport à l'emplacement initial de l'implantation. Ainsi, pour tenir compte de la diffusion latérale, il faut prévoir une distance minimum entre deux masques de définition de régions implantées destinées à former des couches enterrées de types opposés. Sinon, des couches enterrées voisines se rejoindraient, ce qui entraîne divers inconvénients bien connus de l'homme de métier, notamment en ce qui concerne la tenue en tension du dispositif et la création de capacités parasites, sans compter le fait que, par suite du mélange entre des zones implantées de types distincts, on n'obtient pas les caractéristiques de dopage initialement visées.

De plus, intrinsèquement, le fait de devoir prévoir des diffusions après implantation des couches enterrées entraîne que l'on ne peut pas descendre en dessous d'une dimension minimale effective pour les ouvertures d'implantation si l'on veut obtenir des niveaux de dopage optimaux avec des doses d'implantation raisonnables.

A titre d'exemple, la figure 2 représente des profils de diffusion résultant de l'implantation d'arsenic à travers des ouvertures de diverses largeurs dans des masques d'implantation. La direction x est parallèle à la surface d'un substrat, et le profil est étudié à une profondeur à laquelle apparaît le maximum de concentration. Ces profils correspondent à une simulation bidimensionnelle. Les résultats seront pires en pratique car il faudrait tenir compte de la troisième dimension. Dans les divers cas représentés la dose d'implantation était de 4.10¹⁵ at./cm². En figure 2, les ordonnées sont en atomes/cm³ et les abscisses en micromètres.
- Pour la courbe 11, la largeur d'ouverture de masque était de 0,4 *µ*m ; on voit que la concentration maximum au centre de la couche enterrée est de 10¹⁹ atomes/cm³ et la largeur à mi-hauteur de 1,6 *µ*m.
- Pour la courbe 12, la largeur d'ouverture de masque était de 1,4 *µ*m ; on voit que la concentration maximum au centre de la couche enterrée est de 2.10¹⁹ atomes/cm³ et la largeur à mi-hauteur de 2,6 *µ*m.
- Pour la courbe 13, la largeur d'ouverture de masque était de 3,4 *µ*m ; on voit que la concentration maximum au centre de la couche enterrée est de 2,6.10¹⁹ atomes/cm³ et la largeur à mi-hauteur de 4 *µ*m.
- Pour la courbe 14, la largeur d'ouverture de masque était de 7,4 *µ*m ; on voit que la concentration maximum au centre de la couche enterrée est de 2,6.10¹⁹ atomes/cm3 et la largeur à mi-hauteur de 8 *µ*m.

Ainsi, on voit que, dans ces conditions, le dopage maximum visé au centre de la couche enterrée n'est obtenu que pour un masque d'une ouverture supérieure à 3,4 *µ*m. Pour des masques plus petits, en raison des diffusions, la concentration maximum diminue. En outre, même pour un masque de dimension minimale (0,4 *µ*m), par suite de la diffusion latérale, la courbe résultante s'étend sur une largeur supérieure à 2 *µ*m. Il faut donc prévoir une distance de garde notable entre deux couches enterrées distinctes, par exemple supérieure à 1,5 *µ*m.

Le brevet US 4 862 240 propose de séparer deux couches enterrées de type opposé, en contact l'une avec l'autre, par une tranchée. Un inconvénient de ce procédé est que la tranchée doit être suffisamment large pour éliminer la zone d'interpénétration des dopants de type opposé.

La présente invention vise à remédier aux divers inconvénients exposés ci-dessus et notamment à permettre la formation de couches enterrées proches les unes des autres et à niveau de dopage maximum élevé.

Pour atteindre cet objet, la présente invention prévoit un procédé de formation de couches enterrées disjointes et proches les unes des autres dans un composant semiconducteur, comprenant les étapes consistant à former par implantation des zones dopées dans un substrat semiconducteur ; procéder à un recuit juste suffisant pour supprimer les défauts cristallins résultant de l'implantation ; déposer une couche épitaxiale ; creuser des tranchées délimitant chaque région implantée ; et procéder à un recuit des couches enterrées dont la diffusion latérale est bloquée par les tranchées qui sont plus profondes que l'extension vers le bas des diffusions résultant des implantations.

Selon un mode de réalisation de la présente invention, la garde entre le masque de formation des tranchées et le masque de formation des implantations est de l'ordre de 0,2 *µ*m.

Selon un mode de réalisation de la présente invention, le premier recuit est réalisé à une température de l'ordre de 900°C pendant une durée inférieure à une heure.

Selon un mode de réalisation de la présente invention, le deuxième recuit est réalisé à une température supérieure à 1000°C pendant une durée supérieure à 20 minutes.

Selon un mode de réalisation de la présente invention, les implantations sont réalisées à une dose comprise entre 10¹⁴ et 10¹⁶ atomes/cm².

Selon un mode de réalisation de la présente invention, l'une au moins des zones implantées est formée au-dessus d'une région préalablement implantée du type de conductivité opposé et préalablement recuite.

Selon un mode de réalisation de la présente invention, la région préalablement implantée diffuse suffisamment pour s'étendre sous des tranchées et rejoindre des couches enterrées formées de l'autre côté de ces tranchées.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1, décrite précédemment, illustre une structure classique de couches enterrées ;
la figure 2, décrite précédemment, représente une courbe de concentration en fonction de la largeur d'une ouverture d'implantation ;
les figures 3A à 3C illustrent des étapes successives d'un procédé selon la présente invention ; et
les figures 4A à 4C illustrent des étapes successives d'une variante d'un procédé selon la présente invention.

Comme le représente la figure 3A, une première étape du procédé selon la présente invention consiste à former dans un substrat de silicium monocristallin 1 des régions implantées 21, 22, 23 puis à effectuer un recuit minimum pour une restructuration du silicium et une élimination des défauts. On effectuera par exemple un recuit à 850°C pendant 20 minutes. Après cela, on forme une couche épitaxiale 2 par une épitaxie à basse température, par exemple sur une épaisseur de 1,5 à 2 *µ*m. Pendant cette épitaxie, qui est couramment réalisée à une température de l'ordre de 900°C, les atomes implantés dans les régions 21, 22, 23 ne diffusent pratiquement pas.

A une étape suivante, illustrée en figure 3B, on réalise des tranchées étroites 25 qui entourent les régions implantées 21, 22, 23. Les tranchées auront la largeur minimale permise par la technologie de fabrication, par exemple aujourd'hui de l'ordre de 0,3 *µ*m et seront distantes des limites des régions 21, 22, 23 d'une distance de garde suffisante pour que l'on soit certain que, en dépit d'éventuels défauts de fabrication, les tranchées ne coupent pas les limites de diffusion des régions 21, 22, 23 à ce stade du procédé. A titre d'exemple, on prévoira une distance de garde de 0,2 *µ*m entre les limites estimées des régions diffusées et les bords des tranchées.

C'est uniquement à une étape ultérieure, illustrée en figure 3C, que l'on procédera à un recuit à haute température, par exemple 1100°C pendant 20 minutes, pour assurer une activation et une diffusion des zones implantées 21, 22, 23 destinées à former des couches enterrées 31, 32, 33 et pour passiver simultanément les flancs des tranchées. Les tranchées sont creusées suffisamment profondément pour que les limites inférieures des couches 31, 32, 33 ne descendent pas en dessous du fond des tranchées.

La distance de garde latérale entre les limites des tranchées 25 et les frontières des zones implantées 21, 22, 23 étant de façon générale très inférieure à l'étendue de diffusion latérale normale des zones implantées 21, 22, 23, la structure pourra avoir des dimensions réduites par rapport à ce qui est illustré en figure 1. D'autre part, en ce qui concerne les couches enterrées les plus étroites, par exemple les zones 31 et 33, selon un avantage de la présente invention, on obtient dans ces zones une concentration de dopants accrue après diffusion, du fait que les dopants se dispersent peu par diffusion latérale.

Un autre avantage de la prévision de tranchées formées de façon à limiter l'extension latérale de dopants implantés est que, étant donné que les flancs des tranchées sont en contact avec des zones très dopées, il n'est pas nécessaire de prévoir des implantations/diffusions spécifiques d'arrêt de canal comme on en réalise souvent au fond de tranchées.

Enfin, par rapport au cas où l'on réalise une première étape de diffusion assez prolongée avant épitaxie puis une deuxième étape de diffusion après épitaxie, le front de dopage du côté supérieur selon la présente invention est plus arrondi, ce qui est plus favorable pour éviter les phénomènes de verrouillage (latch up) quand on réalise dans la couche épitaxiale des transistors de type MOS. Dans des structures de type bipolaire dans lesquelles la couche enterrée est destinée à correspondre à un collecteur, on cherchera au contraire à augmenter la raideur des fronts de diffusion, et pour cela on réalise de préférence, après épitaxie, une implantation profonde de collecteur de même type que l'implantation de couche enterrée.

C'est volontairement que dans l'exposé précédent, on n'a pas indiqué de type de conductivité particulier pour le substrat et la couche épitaxiale. Dans de nombreux cas, le substrat est faiblement dopé de type P et la couche épitaxiale est de type N, éventuellement ajustée ou inversée en tant que de besoin. A titre d'exemple, la couche enterrée 32 est de type N⁺ et les couches enterrées 31 et 33 de type P⁺. Toutefois, toute autre configuration de dopage des diverses couches pourra être adoptée selon les besoins.

De même, le substrat ne sera pas nécessairement un substrat homogène, mais éventuellement une couche peu dopée formée sur une couche plus dopée du même type ou du type de conductivité opposé. Le substrat pourra également correspondre à une couche épitaxiale formée sur un substrat de même type de conductivité ou de type de conductivité distinct.

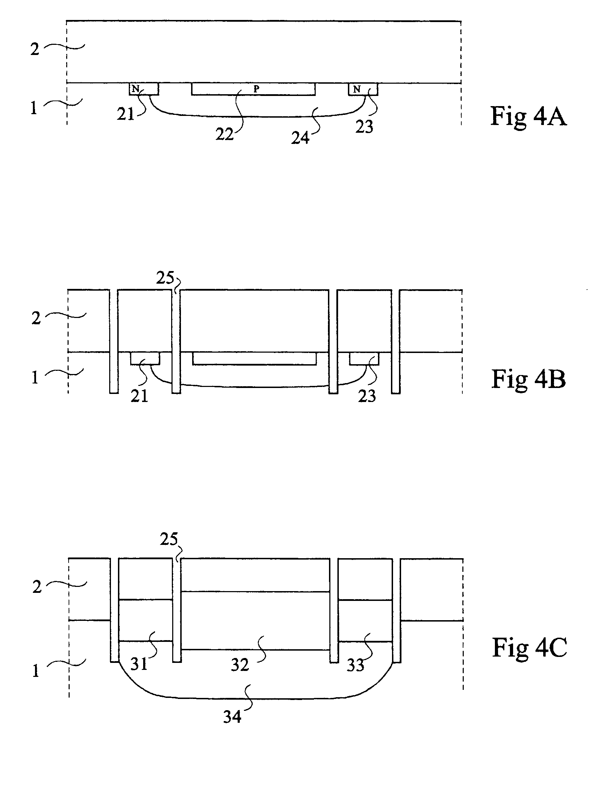

Les figures 4A à 4C illustrent une variante de l'invention. On part comme précédemment d'un substrat 1 dans lequel on a formé des implantations 21, 22 et 23. Toutefois, cette fois-ci, sous l'implantation 22 a été formée une implantation 24 correspondant à des atomes dopants du type de conductivité opposé. Par exemple, les implantations 21 et 23 seront de type N, l'implantation 22 de type P et l'implantation 24 de type N. Les dopants correspondant à l'implantation 24 sont implantés plus profondément que les dopants correspondant à l'implantation 22 et/ou ont une vitesse de diffusion plus élevée. De préférence, comme cela est représenté, la couche 24 est recuite et diffusée avant les implantations 21, 22, 23. L'ensemble est surmonté d'une couche épitaxiale 2. A l'étape de la figure 4B, comme à l'étape de la figure 3B, on forme des tranchées 25 séparant les diverses zones implantées puis à l'étape de la figure 4C, on procède à un recuit d'activation des couches enterrées.

Les tranchées 25 sont choisies suffisamment profondes pour bloquer toute extension latérale des régions diffusées 31, 32 et 33 résultant des régions implantées 21, 22, 23. Toutefois, l'extension de la zone diffusée provenant de l'implantation 24 passe sous les tranchées 25 adjacentes et rejoint les couches enterrées 31 et 33. Ceci permet, si on réalise un caisson de type P dans la partie de couche épitaxiale située au-dessus de la couche enterrée 32, d'obtenir une isolation par jonction du caisson P, surmontant la couche P⁺, vis-à-vis du substrat 1. La polarisation en tension inverse de cette jonction se fait par l'intermédiaire des couches enterrées 31 et 33. Cette configuration économise une surface notable puisque l'extension latérale est limitée par les tranchées.

Bien entendu, la présente invention est susceptible de nombreuses autres variantes et modifications qui apparaîtront à l'homme de l'art. En particulier, alors que l'on a décrit l'ensemble des recuits de diffusion des couches enterrées comme réalisées immédiatement après la formation de la couche épitaxiale, on pourra prévoir un recuit partiel à ce moment suivi d'un ou plusieurs recuits complémentaires correspondant aux recuits d'autres zones de la structure formées ultérieurement.

Par ailleurs, bien que cela ne soit pas décrit, on réalisera de façon classique un isolement des parois des tranchées et un remplissage de ces tranchées. L'isolement pourra par exemple être réalisé par une oxydation thermique, éventuellement en même temps que les recuits de redistribution des dopants et ces tranchées pourront être complètement remplies par dépôt d'une substance isolante ou conductrice, par exemple de l'oxyde de silicium ou du silicium polycristallin.

## Revendications

1. Procédé de formation de couches enterrées disjointes et proches les unes des autres dans un composant semiconducteur, **caractérisé en ce qu'**il comprend les étapes suivantes :
former par implantation des zones dopées disjointes (21, 22, 23) dans un substrat semiconducteur (1) ;
procéder à un premier recuit juste suffisant pour supprimer les défauts cristallins résultant de l'implantation ;
déposer une couche épitaxiale (2) ;
creuser des tranchées (25) délimitant chaque région implantée ;
procéder à un deuxième recuit des couches enterrées dont la diffusion latérale est bloquée par lesdites tranchées, lesdites tranchées étant plus profondes que l'extension vers le bas des diffusions résultant desdites implantations, la distance entre la limite d'une zone implantée et la tranchée qui la délimite étant suffisamment petite pour que, après le deuxième recuit, cette zone implantée et diffusée (31, 32, 33) présente un dopage homogène.

2. Procédé selon la revendication 1, **caractérisé en ce que** la garde entre le masque de formation des tranchées et le masque de formation des implantations est de l'ordre de 0,2 *µ*m.

3. Procédé selon la revendication 1, **caractérisé en ce que** le premier recuit est réalisé à une température de l'ordre de 900°C pendant une durée inférieure à une heure.

4. Procédé selon la revendication 1, **caractérisé en ce que** le deuxième recuit est réalisé à une température supérieure à 1000°C pendant une durée supérieure à 20 minutes.

5. Procédé selon la revendication 1, **caractérisé en ce que** lesdites implantations sont réalisées à une dose comprise entre 10¹⁴ et 10¹⁶ atomes/cm².

6. Procédé selon la revendication 1, **caractérisé en ce que** l'une au moins (22) des zones implantées est formée au-dessus d'une région préalablement implantée du type de conductivité opposé et préalablement recuite.

7. Procédé selon la revendication 6, **caractérisé en ce que** ladite région préalablement implantée diffuse suffisamment pour s'étendre sous des tranchées et rejoindre des couches enterrées formées de l'autre côté de ces tranchées.
